# EUROPEAN PATENT SPECIFICATION

(11) **EP 3 493 023 B1**
(45) Date of publication and mention of the grant of the patent: **07.07.2021**
(21) Application number: 17204661.7
(22) Date of filing: 30.11.2017
(51) Int. Cl.: G06F 1/20, G06F 1/26, H05K 7/20

(54) **POWER SUPPLY**
STROMVERSORGUNG
ALIMENTATION ÉLECTRIQUE

(43) Date of publication of application: 05.06.2019
(73) Proprietor: LISTAN GmbH & Co. KG, 21509 Glinde (DE)
(72) Inventor: Minkin, Stanislav, 21509 Glinde (DE); Rex, Christian-Michael, 21509 Glinde (DE)
(74) Representative: 2K Patentanwälte Blasberg Kewitz & Reichel

(56) References cited:
- US-A- 5 522 700
- US-A1- 2003 202 879
- US-A1- 2009 147 478
- US-A1- 2009 290 293

## Description

### FIELD OF THE INVENTION

The present invention is related to a power supply, particularly to a power supply using a heat-dissipating fan without a barrier wall around a fan blade set.

### BACKGROUND OF THE INVENTION

At present, each of all power supplies used in personal computers includes a fan for heat-dissipation. The general arrangement of the fan is disclosed in patents, such as US 20090290293, US 20100284149, US 20080266793, US 6,074,296, US 2003/202879 A1, US 5522700A, US 2009/147478A1 and so on.

It may be clearly understood that, from patents listed above, each of all currently used fans is provided with an outer frame, via which the fan is mounted on a housing of the power supply. Additionally, a flow-guiding channel, provided for a fan blade set to be suspended therein, is further delimited by the outer frame, such that heat-dissipating airflow generated by the fan is discharged through the flow-guiding channel.

In this manner, although heat-dissipating airflow generated by the fan is collected, the heat-dissipating airflow is allowed to only dissipate heat locally in disguise without providing heat-dissipation for each element within the power supply effectively. Thus, effect of heat-dissipation is reduced.

### SUMMARY OF THE INVENTION

It is the main object of the present invention to solve the problem of reduced effect of heat-dissipation due to an outer frame generally provided for a fan used in a power supply.

For achieving the above object, the present invention provides a power supply, including a bottom case, a top cover, a circuit board and a heat-dissipating fan. The bottom case and the top cover are fitted together to delimit an accommodating space. The circuit board is mounted on the bottom case and located within the accommodating space. The circuit board is provided thereon with a plurality of electronic components and a plurality of heat-dissipating elements, each of the plurality of heat-dissipating element being provided correspondingly to one of the plurality of electronic components and allowed to conduct heat, respectively. Each of the plurality of heat-dissipatings elements is provided with a mounting hole. The heat-dissipating fan includes a supporting frame, a driving module provided on the supporting frame, and a fan blade set covering the driving module and being driven by the driving module to rotate. The supporting frame is presented as a flat plate and provided with a plurality of connecting ribs, each of the plurality of connecting ribs being respectively connected to one of the mounting holes. Moreover, the heat-dissipating fan is not provided with a barrier wall around the fan blade set.

In one embodiment, the mounting hole is replaced by a gap formed between a plurality of fins on each of the plurality of heat-dissipating elements.

In one embodiment, lines interconnecting positions where the mounting holes are located are formed as a polygon.

In one embodiment, the plurality of heat-dissipating elements are of equal height, in such a way that top edges of the plurality of heat-dissipating elements are located on overlapping parallel lines, and each of the mounting holes is respectively located on the top edge of each of the plurality of heat-dissipating elements.

In one embodiment, the top cover is provided with at least one vent facing the heat-dissipating fan.

Besides, the present invention also provides a power supply, the power supply including a bottom case, a top cover, a circuit board and a heat-dissipating fan. The bottom case and the top cover are fitted together to delimit an accommodating space. The circuit board is mounted on the bottom case and located within the accommodating space. The heat-dissipating fan includes a supporting frame, a driving module provided on the supporting frame, and a fan blade set covering the driving module and being driven by the driving module to rotate. The supporting frame is provided with a main body provided for the driving module and the fan blade set to be installed, as well as a plurality of supporting posts connected to the main body and fixed on the circuit board, respectively. The supporting frame is not provided with a barrier wall around the fan blade set.

In one embodiment, the top cover is provided with at least one vent facing the heat-dissipating fan.

In one embodiment, each of the plurality of supporting posts and the main body are two members, which may be separated from each other.

In one embodiment, lines interconnecting positions where the plurality of supporting posts are located on the circuit board are formed as a polygon.

In one embodiment, the supporting frame is provided with a plurality of connecting ribs, each of the plurality of connecting ribs being respectively provided between two adjacent of the plurality of supporting posts.

In comparison with the conventional art, the feature obtained by what is disclosed above in the present invention is as follows: the heat-dissipating fan disclosed in the present invention being not provided with a barrier wall around the fan blade set. In other words, the heat-dissipating fan of the present invention is not provided with an outer frame. Thus, the heat-dissipating airflow generated by the heat-dissipating fan is not restricted by the outer frame any more in the present invention, while heat dissipation in relation to each of the plurality of electronic components or member within the accommodating space is allowed so as to further enhance effect of heat-dissipation in comparison with the conventional art. On the other hand, the heat-dissipating fan of the present invention is not provided with an outer frame so as to decrease the noise produced by the heat-dissipating fan from working.

### BRIEF DESCRIPTION OF THE DRAWINGS

Fig. 1 is an exploded diagram of a power supply of one embodiment of the present invention.
Fig. 2 is an exploded diagram of a partial structure of the power supply of the embodiment of the present invention.
Fig. 3 is a structural cross-section view of the power supply of the embodiment of the present invention.
Fig. 4 is a structural cross-section view of a power supply of another embodiment of the present invention.
Fig. 5 is a top view of a partial structure of a power supply of one embodiment of the present invention.
Fig. 6 is an exploded diagram of a partial structure of a power supply of another embodiment of the present invention.
Fig. 7 is a structural cross-section view of the power supply of another embodiment of the present invention.
Fig. 8 is a top view of a partial structure of a power supply of another embodiment of the present invention.
Fig. 9 is an exploded diagram of a structure of a power supply of another embodiment of the present invention.
Fig. 10 is an exploded diagram of a top cover of another embodiment of the present invention.

### DETAILED DESCRIPTION OF THE PREFERRED EMBODIMENTS

The detailed description and technical content related to the present invention is described in accompany with the drawings as follows.

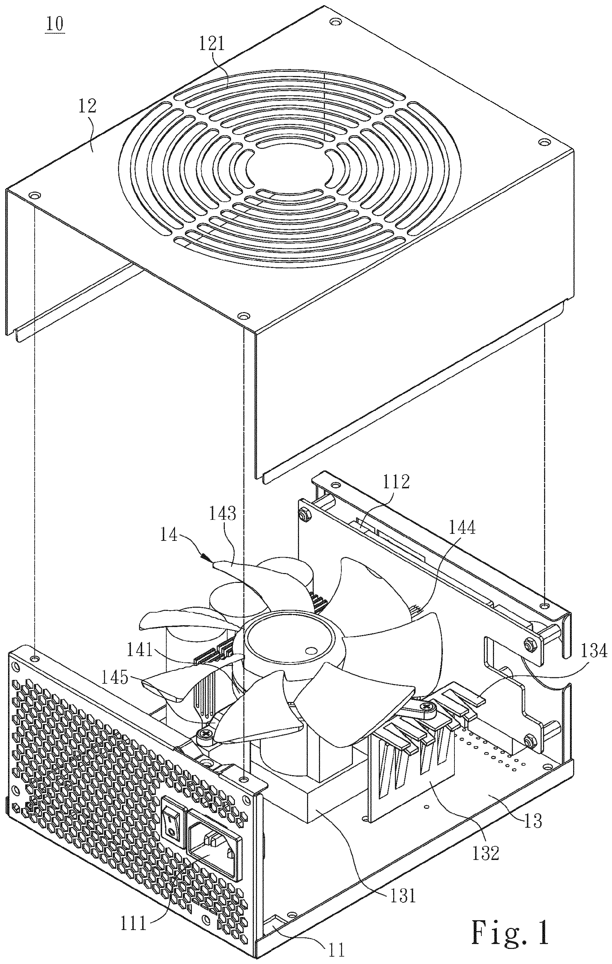

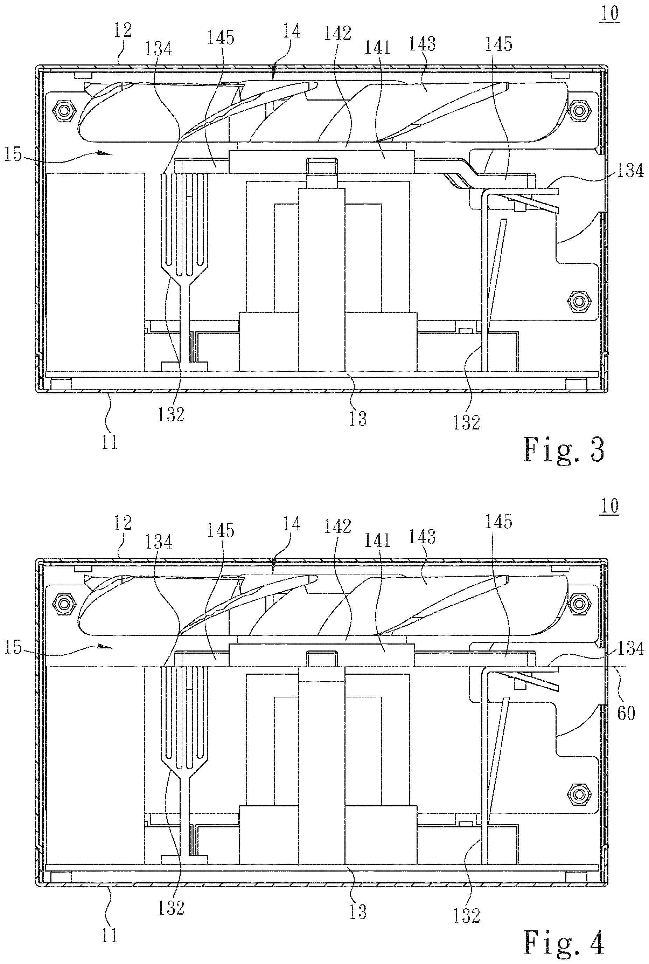

Referring to Figs. 1, Figs. 2, Figs. 3, Figs. 4, Figs. 5, the present invention provides a power supply 10. The power supply 10 may be implemented according to the ATX specification. The power supply 10 includes a bottom case 11, a top cover 12, a circuit board 13 and a heat-dissipating fan 14. In this case, the bottom case 11 and the top cover 12 may be presented in the form of a mutually fitted structure. In one embodiment, each of the bottom case 11 and the top cover 12 is formed as U-shaped structure, respectively, such that the bottom case 11 and the top cover 12 are fitted together to delimit an accommodating space 15. Further, the top cover 12 may be provided with a vent 121. Next, in the present invention, the bottom case 11 and the top cover 12 may be implemented with many components according to the design. Furthermore, the bottom case 11 may be further mounted at the sides thereof with a power input port 111 and at least one power output port 112. The power input port 111 and the power output port 112 are provided at different sides of the bottom case 11. The number of the power output ports 112 may be modified as required for implementation.

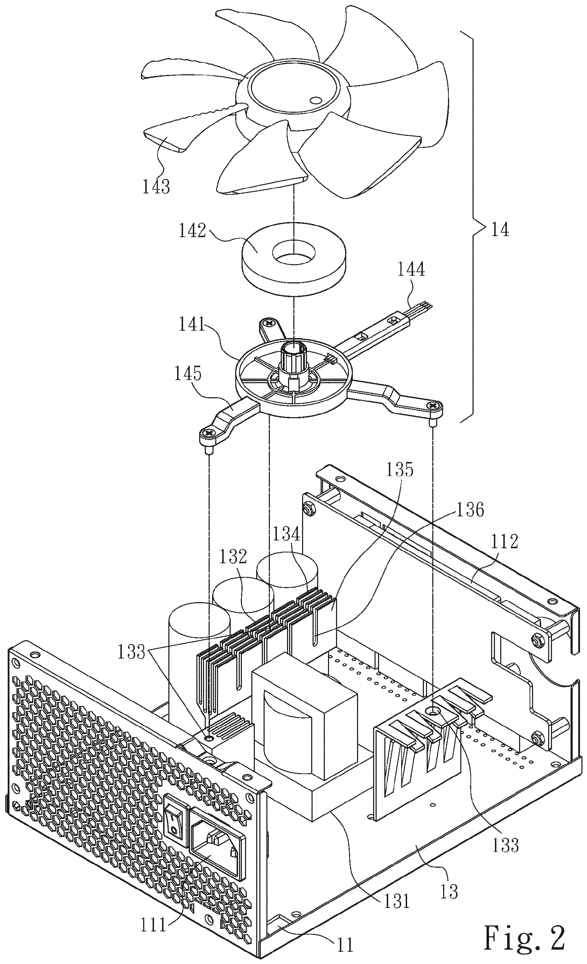

Next, the circuit board 13 is mounted on the bottom case 11 and located within the accommodating space 15. The circuit board 13 is laid thereon with a plurality of electronic components 131 and a plurality of heat-dissipating elements 132, each of the plurality of heat-dissipating elements 132 being provided correspondingly to one of the plurality of electronic components 131, respectively. In this case, the plurality of electronic components 131 are combined as at least a power calibration circuit, an electric power conversion circuit and etc., after being arranged. Further, each of plurality of the heat-dissipating elements 132 is contacted with one of the plurality of electronic components 131, to which each of the plurality of heat-dissipating elements 132 is provided correspondingly, so as to conduct heat. Each of the plurality of heat-dissipating elements 132 is provided with a mounting hole 133. In one embodiment, the plurality of heat-dissipating elements 132 are of equal height, in such a way that top edges 134 of the plurality of heat-dissipating elements 132 are located on overlapping parallel lines 60. Moreover, each of the mounting holes 133 is located on the top edge 134 of each of the plurality of heat-dissipating elements 132, respectively. Furthermore, the mounting hole 133 referred to in the present invention may be replaced by a gap 136 formed between a plurality of fins 135 on the plurality of heat-dissipating elements 132, just as illustrated in Fig. 2.

Furthermore, the heat-dissipating fan 14 of this embodiment includes a supporting frame 141, a driving module 142 provided on the supporting frame 141, and a fan blade set 143 covering the driving module 142 and being driven by the driving module 142 to rotate. The heat-dissipating fan 14 is further connected to a power feeder (not illustrated in this figure) on the circuit board 13 via a power line 144, so as to acquire electric power required for rotation. Further, the driving module 142 is implemented as an electric motor configuration. Additionally, the supporting frame 141 of the present invention is presented as a flat plate and provided with a plurality of connecting ribs 145, each of the plurality of connecting ribs 145 being connected to one of the mounting holes 133, respectively. The pattern of each of the plurality of connecting ribs 145 may be modified in accordance with the position or pattern of each of the plurality of heat-dissipating elements 132 on which the mounting hole 133 is provided. Further, the heat-dissipating fan 14 of the present invention is not provided with a barrier wall, which is provided around the fan blade set 143. In other words, the heat-dissipating fan 14 is not provided with a flow-limiting channel, which is delimited by an outer frame and in which the fan blade set 143 is suspended. In this way, the heat-dissipating fan 14 is allowed for generating heat-dissipating airflow within the accommodating space 15 more specifically when operated electrically, so as to enhance the heat-dissipation performance.

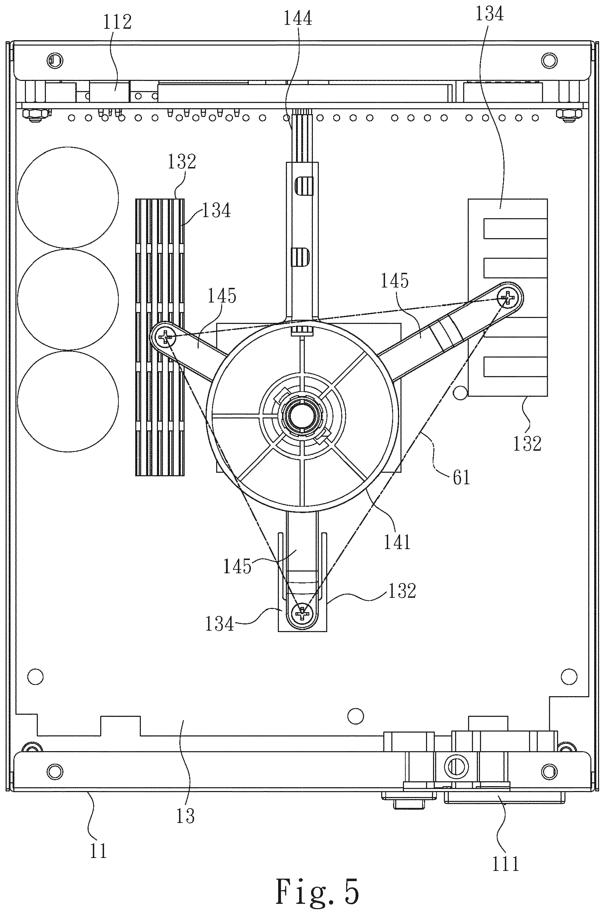

In one embodiment, referring to Fig. 5, for the enhancement of stability of the heat-dissipating fan 14 during rotation, the mounting holes 133 may be mapped out, such that a polygon 61 is formed by lines interconnecting positions where the mounting holes 133 are located. In this way, the heat-dissipating fan 14 may be supported more stably, so as to reduce the possibility of sway of the heat-dissipating fan 14 during rotation. Nevertheless, the amount of the mounting hole 133 used in the embodiment of the present invention may be, for example but not limited to, three. Other appropriate amount of the mounting hole 133 is also applicable in the present invention.

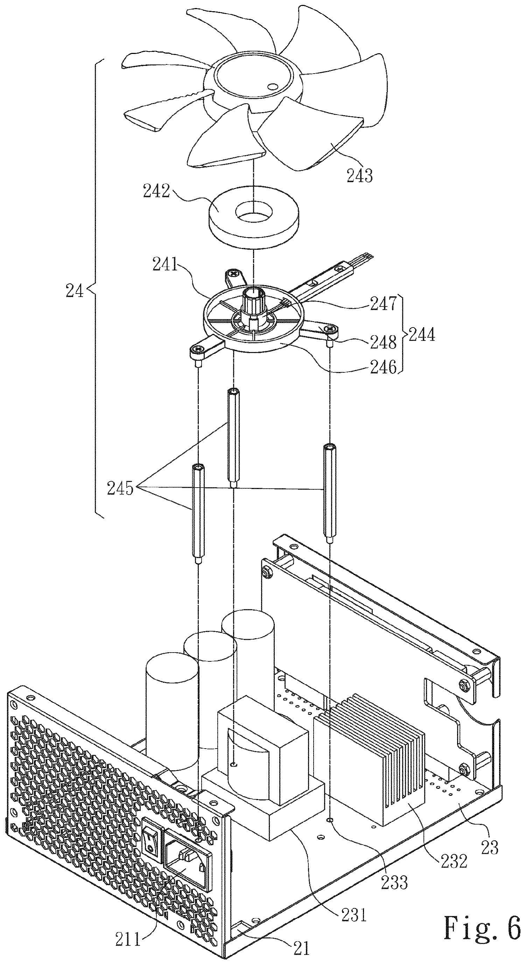

Referring to Fig. 6, Fig. 7 and Fig. 10, another embodiment is also proposed, besides the above power supply 10, in the present invention. Different numerals are used below, however, for distinguishing between the two embodiments. In this embodiment, the power supply 20 includes a bottom case 21, a top cover 22, a circuit board 23 and a heat-dissipating fan 24. In this case, the bottom case 21 and the top cover 22 are fitted together to delimit an accommodating space 25. The top cover 22 may be provided with at least one vent 221 facing the heat-dissipating fan 24. Further, the circuit board 23 is mounted on the bottom case 21 and located within the accommodating space 25. The circuit board 23 is laid with a plurality of electronic components 231 and the plurality of heat-dissipating elements 232 as required for implementation. The electronic components 231 are combined as a power calibration circuit, an electric power conversion circuit and etc., after being arranged. Moreover, the plurality of heat-dissipating elements 232 may be laid as required for implementation.

Further, the heat-dissipating fan 24 includes a supporting frame 241, a driving module 242 provided on the supporting frame 241, and a fan blade set 243 covering the driving module 242 and being driven by the driving module 242 to rotate. In this embodiment, the supporting frame 241 is provided with a main body 244 provided for the driving module 242 and the fan blade set 243 to be installed, as well as a plurality of supporting posts 245 connected to the main body 244 and fixed on the circuit board 23, respectively. More specifically, the main body 244 is presented as a flat plate. The main body 244 is provided with at least a flat portion 246 provided for the driving module 242 to be placed, as well as a protruding portion 247 connected to the flat portion 246 and located at the center of the main body 244 for the fan blade set 243 to be fitted. The main body 244 further includes a plurality of connecting portions 248 extending from the edge of the flat portion 246, respectively. Each of the connecting portions 248 is corresponded to one of the plurality of supporting posts 245, respectively. Next, the circuit board 23 is provided with a plurality of through-holes 233 provided for the plurality of supporting posts 245 to be installed, respectively. Moreover, the main body 244 is held up by the plurality of supporting posts 245 together, such that the main body 244 is installed at a height 62 relative to the circuit board 23, in which each of the plurality of supporting posts 245 is at least higher than the highest one of the electronic components 231. Moreover, in one embodiment, each of the plurality of supporting posts 245 and the main body 244 are two members, which may be separated from each other. Furthermore, the heat-dissipating fan 24 of this embodiment is not provided with a barrier wall, which is provided around the fan blade set 243; that is to say, the heat-dissipating fan 24 is not provided with a flow-limiting channel, which is delimited by an outer frame and in which the fan blade set 243 is suspended.

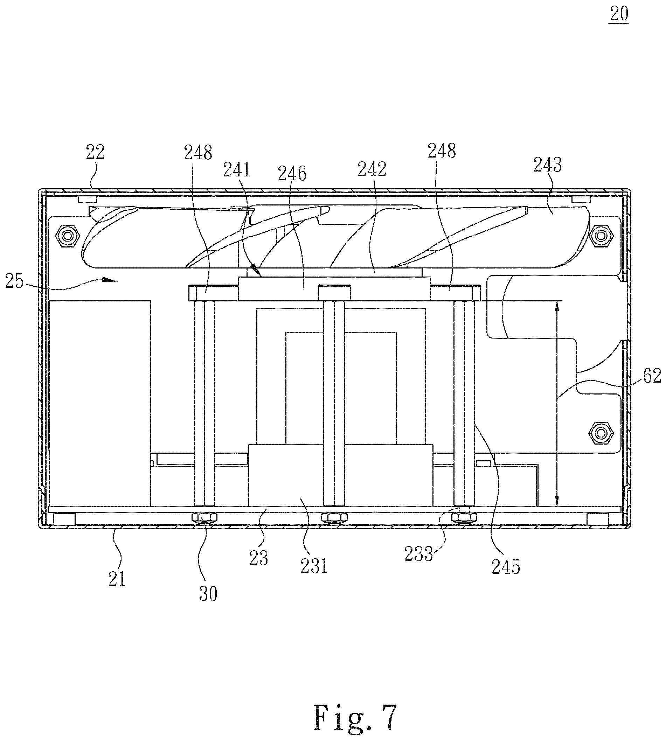

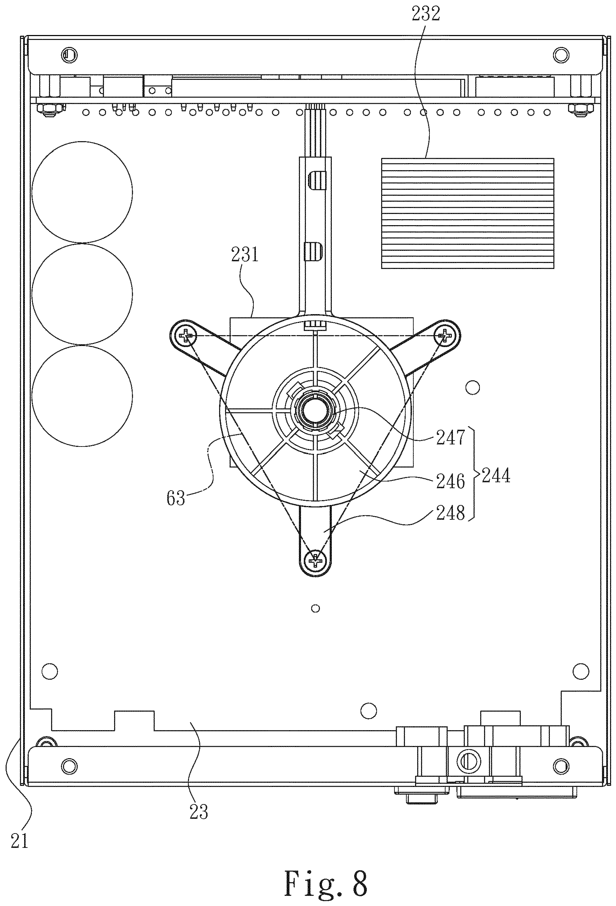

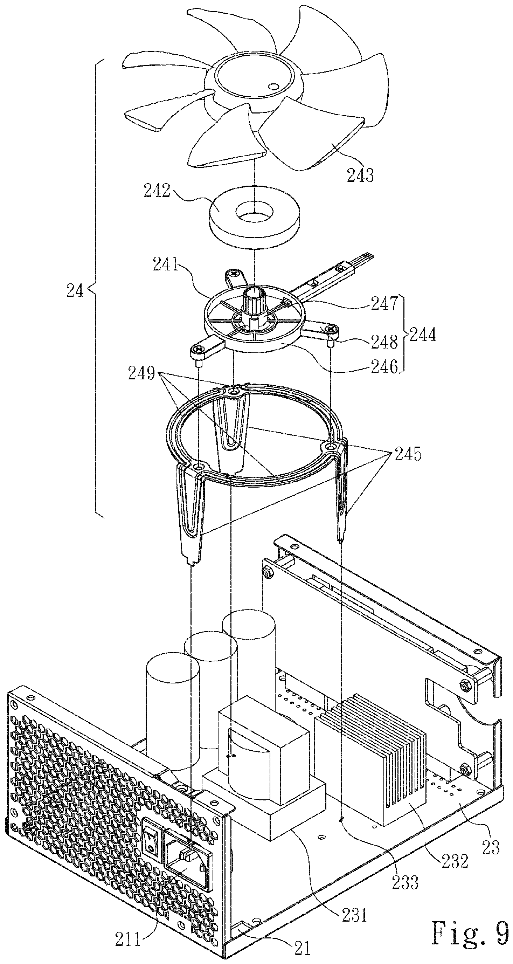

In one embodiment, referring to Fig.7 and Fig. 8, for the enhancement of stability of the heat-dissipating fan 24 during rotation, the positions where the plurality of supporting posts 245 are located on the circuit board 23 may be mapped out, such that a polygon 63 is formed by lines interconnecting positions where the plurality of supporting posts 245 are located on the circuit board 23. Nevertheless, the amount of the supporting post 245 used in the embodiment may be, for example but not limited to, three. Other appropriate amount of the supporting post 245 is also applicable in the present invention. Furthermore, a fixing component 30 is further implemented with each of the plurality of supporting posts 245, and fixing each of the plurality of supporting posts 245 on the circuit board 23, wherein the fixing component 30 may be a nut, a screw, and so on. In addition, referring to Fig. 9, the supporting frame 241 in one embodiment may be provided with a plurality of connecting ribs 249, each of the plurality of connecting ribs 249 being provided between two adjacent of the plurality of supporting posts 245, respectively. The plurality of connecting ribs 249 may be provided for enhancing the structural strength of the plurality of supporting posts 245. The pattern of the plurality of connecting ribs 249 may be modified as required for implementation.

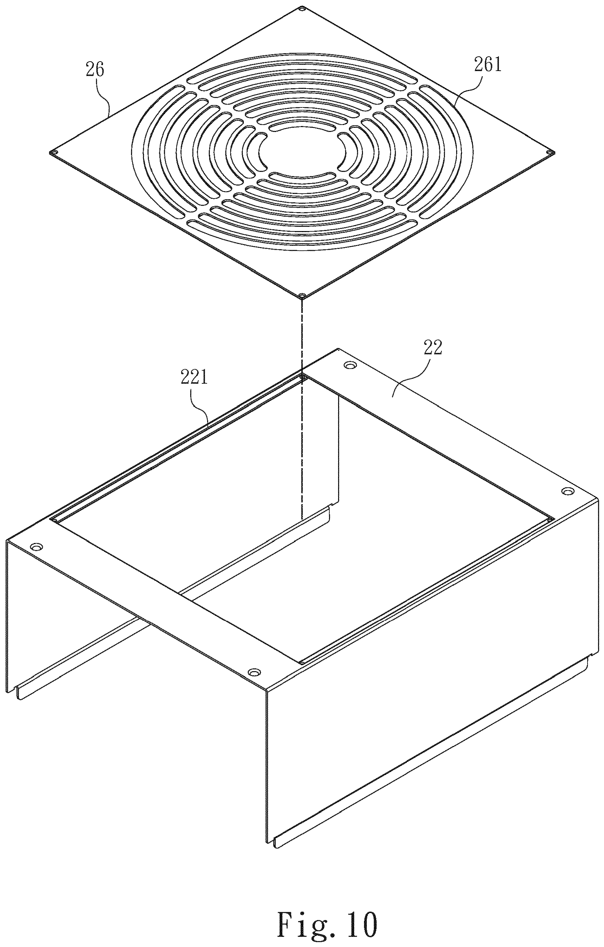

Additionally, the top cover 22 is provided thereon with at least one vent 221 facing the heat-dissipating fan 24. In one embodiment, the top cover 22 is provided thereon with the vents 221, and the vents 221 may be laid out and then formed in accordance with a designed pattern. In addition, it is also possible to modify the opening area of the vent 221 provided on the top cover 22 as required for implementation, such that the vent 221 may be provided for a decorative baffle 26 to be installed therein. The decorative baffle 26 may be provided with a plurality of air-permeable holes 261, which are cuttingly provided in accordance with a designed pattern, just as illustrated in Fig. 10. In this embodiment, moreover, the power supply 20 is provided for a user with a choice among a variety of the decorative baffles 26 on the basis of personal preference.

## Claims

1. A power supply, comprising a bottom case (11), a top cover (12), a circuit board (13) and a heat-dissipating fan (14), wherein said bottom case (11) and said top cover (12) are fitted together to delimit an accommodating space (15), said circuit board (13) is mounted on said bottom case (11) and located within said accommodating space (15), and said circuit board (13) is provided thereon with a plurality of electronic components (131) which are combined as at least a power calibration circuit or an electric power conversion circuit, said heat-dissipating fan (14) includes a driving module (142) and a fan blade set (143) covering said driving module (142) and being driven by said driving module (142) to rotate;
**characterized in that**
said circuit board (13) comprises a plurality of heat-dissipating elements (132), each of said plurality of heat-dissipating elements (132) is provided correspondingly to one of said plurality of electronic components (131) and allowed to conduct heat, respectively, and each of said plurality of heat-dissipating elements (132) is provided with a mounting hole (133); and
said heat-dissipating fan (14) includes a supporting frame (141), said supporting frame (141) comprises a main body, the main body comprises a flat portion provided for said driving module (142) and said fan blade set (143) to be installed, said supporting frame (141) further comprises a plurality of connecting ribs (145) extending from the edge of the flat portion, each of the plurality of connecting ribs (145) is respectively connected to one of said mounting holes (133), and said heat-dissipating fan (14) is not provided with a barrier wall around said fan blade set (143).

2. The power supply according to claim 1, wherein said mounting hole (133) is replaced by a gap (136) formed between a plurality of fins (135) on said plurality of heat-dissipating elements (132).

3. The power supply according to claim 1 or 2, wherein lines interconnecting positions where said mounting holes (133) are located are formed as a polygon (61).

4. The power supply according to any one of claims 1 to 3, wherein said plurality of heat-dissipating elements (132) are of equal height, in such a way that top edges (134) of said plurality of heat-dissipating elements (132) are located on overlapping parallel lines (60), and each of said mounting holes (133) is respectively located on said top edge (134) of each of said plurality of heat-dissipating elements (132).

5. The power supply according to any of the claims 1 to 4, wherein said top cover (22) is provided with at least one vent (221) facing said heat-dissipating fan (24).

6. A power supply, comprising a bottom case (21), a top cover (22), a circuit board (23), and a heat-dissipating fan (24), wherein said bottom case (21) and said top cover (22) are fitted together to delimit an accommodating space (25); said circuit board (23) is mounted on said bottom case (21) and located within said accommodating space (25); and said circuit board (23) is provided thereon with a plurality of electronic components (231) which are combined as at least a power calibration circuit or an electric power conversion circuit, said heat-dissipating fan (24) includes a driving module (242) and a fan blade set (243) covering said driving module (242) and being driven by said driving module (242) to rotate;
**characterized in that**
said heat-dissipating fan (24) includes a supporting frame (241), said supporting frame (241) comprises a main body (244), the main body (244) comprising a flat portion (246) provided for said driving module (242) and said fan blade set (243) to be installed, and a plurality of connecting portions (248) extending from the edge of the flat portion (246), said supporting frame (241) further comprises a plurality of supporting posts (245) respectively connected to said plurality of connecting portions (248) of said main body (244) and fixed on said circuit board (23), said heat-dissipating fan (24) is not provided with a barrier wall around said fan blade set (243), and said main body (244) supported by said plurality of supporting posts (245) is installed at a height relative to said circuit board (23) that is higher than the highest electronic component (231) of said circuit board (23).

7. The power supply according to claim 6, wherein said top cover (22) is provided with at least one vent (221) facing said heat-dissipating fan (24).

8. The power supply according to claim 6 or 7, wherein each of the plurality of supporting posts (245) and said main body (244) are two members, which may be separated from each other.

9. The power supply according to claim 8, wherein lines interconnecting positions where said plurality of supporting posts (245) are located on said circuit board (23) are formed as a polygon (63).

10. The power supply according to claim 9, wherein said supporting frame (241) is provided with a plurality of connecting ribs (249), each of the plurality of connecting ribs (249) being respectively provided between two adjacent of the plurality of supporting posts (245).

## Patentansprüche

1. Eine Stromversorgung mit einem unteren Gehäuse (11), einer oberen Abdeckung (12), einer Schaltungsplatine (13) und einem wärmeableitenden Lüfter (14), wobei das untere Gehäuse (11) und die obere Abdeckung (12) zusammengefügt sind, um einen Aufnahmeraum (15) zu begrenzen, die Schaltungsplatine (13) an dem unteren Gehäuse (11) angebracht und innerhalb des Aufnahmeraums (15) angeordnet ist, und die Schaltungsplatine (13) darauf mit einer Vielzahl von elektronischen Komponenten (131) versehen ist, die als mindestens eine Leistungskalibrierungsschaltung oder eine elektrische Leistungsumwandlungsschaltung kombiniert sind, wobei das wärmeableitende Gebläse (14) ein Antriebsmodul (142) und einen Gebläseflügelsatz (143) aufweist, der das Antriebsmodul (142) abdeckt und durch das Antriebsmodul (142) zum Drehen angetrieben wird;
**dadurch gekennzeichnet, dass**
die Schaltungsplatine (13) eine Vielzahl von wärmeableitenden Elementen (132) umfasst, wobei jedes der Vielzahl von wärmeableitenden Elementen (132) entsprechend einem der Vielzahl von elektronischen Bauteilen (131) vorgesehen ist und Wärme leiten darf, und jedes der Vielzahl von wärmeableitenden Elementen (132) mit einem Montageloch (133) versehen ist; und
das wärmeableitende Gebläse (14) einen Tragrahmen (141) aufweist, der Tragrahmen (141) einen Hauptkörper aufweist, der Hauptkörper einen flachen Abschnitt aufweist, der für das Antriebsmodul (142) und den Gebläseflügelsatz (143) vorgesehen ist, um installiert zu werden, der Tragrahmen (141) ferner eine Vielzahl von Verbindungsrippen (145) umfasst, die sich von der Kante des flachen Abschnitts erstrecken, wobei jede der Vielzahl von Verbindungsrippen (145) jeweils mit einem der Montagelöcher (133) verbunden ist, und der wärmeableitende Lüfter (14) nicht mit einer Sperrwand um den Lüfterflügelsatz (143) herum versehen ist.

2. Die Stromversorgung nach Anspruch 1, wobei das Montageloch (133) durch einen Spalt (136) ersetzt ist, der zwischen einer Vielzahl von Rippen (135) an der Vielzahl von wärmeableitenden Elementen (132) gebildet ist.

3. Die Stromversorgung nach Anspruch 1 oder 2, wobei die Linien, die die Positionen, an denen sich die Befestigungslöcher (133) befinden, miteinander verbinden, als ein Polygon (61) ausgebildet sind.

4. Die Stromversorgung nach einem der Ansprüche 1 bis 3, wobei die mehreren wärmeableitenden Elemente (132) gleich hoch sind, so dass die Oberkanten (134) der mehreren wärmeableitenden Elemente (132) auf sich überlappenden parallelen Linien (60) liegen, und jedes der Befestigungslöcher (133) jeweils auf der Oberkante (134) jedes der mehreren wärmeableitenden Elemente (132) angeordnet ist.

5. Die Stromversorgung nach einem der Ansprüche 1 bis 4, wobei die obere Abdeckung (22) mit mindestens einer Lüftungsöffnung (221) versehen ist, die dem wärmeableitenden Lüfter (24) zugewandt ist.

6. Die Stromversorgung mit einem unteren Gehäuse (21), einer oberen Abdeckung (22), einer Schaltungsplatine (23) und einem wärmeableitenden Lüfter (24), wobei das untere Gehäuse (21) und die obere Abdeckung (22) zusammengefügt sind, um einen Aufnahmeraum (25) zu begrenzen; die Schaltungsplatine (23) an dem unteren Gehäuse (21) angebracht und innerhalb des Aufnahmeraums (25) angeordnet ist; und die Schaltungsplatine (23) darauf mit einer Vielzahl von elektronischen Komponenten (231) versehen ist, die als mindestens eine Leistungskalibrierungsschaltung oder eine elektrische Leistungsumwandlungsschaltung kombiniert sind, wobei das wärmeableitende Gebläse (24) ein Antriebsmodul (242) und einen Gebläseflügelsatz (243) aufweist, der das Antriebsmodul (242) abdeckt und durch das Antriebsmodul (242) angetrieben wird, um sich zu drehen;
**dadurch gekennzeichnet, dass**
das wärmeableitende Gebläse (24) einen Tragrahmen (241) aufweist, wobei der Tragrahmen (241) einen Hauptkörper (244) aufweist, wobei der Hauptkörper (244) einen flachen Abschnitt (246) aufweist, der für das Antriebsmodul (242) und den zu installierenden Gebläseflügelsatz (243) vorgesehen ist, und eine Vielzahl von Verbindungsabschnitten (248), die sich von der Kante des flachen Abschnitts (246) erstrecken, der Tragrahmen (241) ferner eine Vielzahl von Stützpfosten (245) umfasst, die jeweils mit der Vielzahl von Verbindungsabschnitten (248) des Hauptkörpers (244) verbunden und an der Schaltungsplatine (23) befestigt sind, der wärmeableitende Lüfter (24) nicht mit einer Sperrwand um den Lüfterflügelsatz (243) herum versehen ist, und der von der Vielzahl von Stützpfosten (245) gestützte Hauptkörper (244) in einer Höhe relativ zu der Schaltungsplatine (23) installiert ist, die höher ist als die höchste elektronische Komponente (231) der Schaltungsplatine (23).

7. Die Stromversorgung nach Anspruch 6, wobei die obere Abdeckung (22) mit mindestens einer Lüftungsöffnung (221) versehen ist, die dem wärmeableitenden Lüfter (24) zugewandt ist.

8. Die Stromversorgung nach Anspruch 6 oder 7, wobei jeder der mehreren Stützpfosten (245) und der Hauptkörper (244) zwei Elemente sind, die voneinander getrennt werden können.

9. Die Stromversorgung nach Anspruch 8, wobei die Linien, die die Positionen miteinander verbinden, an denen sich die mehreren Stü tzpfosten (245) auf der Schaltungsplatine (23) befinden, als ein Polygon (63) ausgebildet sind.

10. Die Stromversorgung nach Anspruch 9, wobei der Tragrahmen (241) mit einer Vielzahl von Verbindungsrippen (249) versehen ist, wobei jede der Vielzahl von Verbindungsrippen (249) jeweils zwischen zwei benachbarten der Vielzahl von Stützpfosten (245) vorgesehen ist.

## Revendications

1. Une alimentation électrique, comprenant un boîtier inférieur (11), un couvercle supérieur (12), une carte de circuit imprimé (13) et un ventilateur dissipateur thermique (14), dans lequel ledit boîtier inférieur (11) et ledit couvercle supérieur (12) sont montés ensemble pour délimiter un espace de logement (15); ladite carte de circuit imprimé (13) étant montée sur ledit boîtier inférieur (11) et située à l'intérieur dudit espace de logement (15), ladite carte de circuit imprimé (13) étant pourvue sur celle-ci d'une pluralité de composants électroniques (131) qui sont combinés en au moins un circuit de calibration ou un circuit de conversion d'énergie électrique, ledit ventilateur dissipateur de chaleur (14) incluant un modèle d'entraînement (142) et un ensemble d'aubes de ventilateur (143) couvrant ledit module d'entraînement (142) et étant entraînés en rotation par ledit module d'entraînement (142) ;
**caractérisée en ce que**
ladite carte de circuit imprimé (13) comporte une pluralité d'éléments dissipateurs thermiques (132), chacun au sein de ladite pluralité d'éléments dissipateurs thermique (132) étant disposé en correspondance avec l'une parmi ladite pluralité de composants électronique (131) et permettant de conduire la chaleur, respectivement, et chacun parmi ladite pluralité d'élément dissipateurs thermiques (132) étant fourni avec un trou de montage (133) ; et
ledit ventilateur dissipateur thermique (14) comporte un cadre de support (141), ledit cadre de support (141) comprenant un corps principal , le corps principal comprend une partie plate fournie pour ledit module d'entraînement (142) et ledit ensemble d'aubes de ventilateur (143) à installer, ledit cadre de support (141) comprenant en outre une pluralité de nervures de raccordement s'étendant depuis le bord de la partie plate, chaque nervure au sein de la pluralité de nervures de raccordement (145) étant connectée respectivement à un parmi lesdits trous de montage (133), et ledit ventilateur dissipateur thermique (14) n'est pas fourni avec une paroi barrière autour dudit ensemble de panes de ventilateurs (143).

2. L'alimentation électrique selon la revendication 1, dans lequel ledit trou de montage (133) est remplacé par un espace (136) formé entre une pluralité d'ailettes (135) sur ladite pluralité d'éléments dissipateurs de chaleur (132).

3. L'alimentation électrique selon la revendication 1 ou 2, dans laquelle des positions de lignes d'interconnexion où lesdits trous de montage (133) sont situés sont formées sous la forme d'un polygone (61).

4. L'alimentation électrique selon l'une quelconque des revendications 3, dans laquelle ladite pluralité d'éléments dissipateurs de chaleur (132) est de hauteur égale, de telle sorte que les bords supérieurs (134) de ladite pluralité d'éléments dissipateurs de chaleur (132) sont situés sur des lignes parallèles se chevauchant (60), et chacun desdits trous de montage (133) est respectivement situé sur ledit bord supérieur (134) de chacun de ladite pluralité d'éléments dissipateurs de chaleur (132).

5. L'alimentation électrique selon l'une quelconque des revendications 1 à 4, dans laquelle ledit couvercle supérieur (22) est pourvu d'au moins un évent (221) faisant face audit ventilateur dissipateur de chaleur (24).

6. Une alimentation électrique, comprenant un boîtier inférieur (11), un couvercle supérieur (12), une carte de circuit imprimé (23), et un ventilateur dissipateur de chaleur (24), dans lequel ledit boîtier inférieur (11) et ledit couvercle supérieur (12) sont montés ensemble pour délimiter un espace de logement (15); ladite carte de circuit imprimé (13) est montée sur ledit boîtier inférieur (11) et située à l'intérieur dudit espace de logement (15); et ladite carte de circuit imprimé (23) comporte une pluralité de composants électroniques (231) qui sont combinés en au moins un circuit de calibration de puissance ou un circuit de conversion d'énergie électrique, ledit ventilateur dissipateur thermique (24) comprend un module d'entraînement (242) et un ensemble d'aubes de ventilateur (243) recouvrant ledit module d'entraînement (242) et entraînés en rotation par ledit module d'entrainement (242) ;
**caractérisé en ce que**
ledit ventilateur dissipateur de chaleur (24) comprend un châssis de support (241), ledit châssis de support (241) comprenant un corps principal (244), le corps principal (244) comprenant une partie plate (246) fournie pour ledit module d'entraînement (242) et ledit ensemble d'aubes de ventilateurs (243) à installer, et une pluralité de parties de liaison (248) s'étendant depuis le bord de la partie plate (246), ledit châssis de support (241) comprenant en outre une pluralité de montants de support (245) respectivement reliés à ladite pluralité de parties de liaison (248) dudit corps principal (244) et fixé sur ladite carte de circuit imprimé (23), ledit ventilateur dissipateur de chaleur (24) n'étant pas pourvu d'une paroi de barrière autour dudit ensemble d'aubes de ventilateur (243), et ledit corps principal (244) supporté par ladite pluralité de montants de support (245) est installé à une hauteur relative à ladite carte de circuit imprimé (23) qui est plus élevée que le plus haut positionné composant électronique (231) de ladite carte de circuit imprimé (23).

7. L'alimentation électrique selon la revendication 6, dans laquelle ledit couvercle supérieur (22) est pourvu d'au moins un évent (221) faisant face audit ventilateur dissipateur de chaleur (24).

8. L'alimentation électrique selon la revendication 6 ou 7, dans laquelle chaque montant support au sein de la pluralité de montants de support (245) et ledit corps principal (244) sont deux éléments pouvant être séparés l'un de l'autre.

9. L'alimentation électrique selon la revendication 8, dans laquelle les positions de lignes d'interconnexion où est localisée ladite pluralité de montants de support (245) sur ladite carte de circuit imprimé (23) présentent la forme d'un polygone (63).

10. L'alimentation selon la revendication 9, dans laquelle ledit châssis de support (241) est pourvu d'une pluralité de nervures de connexion (249), chaque nervure au sein de la pluralité de nervures de connexion (249) étant respectivement fournie entre deux montants adjacents au sein de la pluralité de montants de support (245).
